# EUROPEAN PATENT SPECIFICATION

(11) **EP 0 871 183 B1**
(45) Date of publication and mention of the grant of the patent: **18.08.2004**
(21) Application number: 97937876.7
(22) Date of filing: 02.09.1997
(51) Int. Cl.: H01F 1/16, H01F 1/24, H01F 1/28, H01F 1/33, H01F 1/37, H05K 9/00

(54) **COMPOSITE MAGNETIC SHEET, METHOD FOR MANUFACTURING THE SAME, AND ELECTROMAGNETIC INTERFERENCE SUPPRESSING MATERIAL**
MAGNETISCHE KOMPOSITFOLIE, HERSTELLUNGSVERFAHREN UND MATERIAL ZUR UNTERDRUCKUNG VON ELEKTROMAGNETISCHEN INTERFERENZEN
FEUILLE MAGNETIQUE COMPOSITE, PROCEDE DE FABRICATION ET MATERIAU PERMETTANT DE SUPPRIMER LES INTERFERENCES ELECTROMAGNETIQUES

(30) Priority: 02.09.1996 JP 23195796
(43) Date of publication of application: 14.10.1998
(73) Proprietor: NEC TOKIN Corporation, Sendai-shi, Miyagi (JP)
(72) Inventor: ONO, Norihiko, Taihaku-ku, Sendai-shi, Miyagi 982 (JP); ITO, Osamu, Hokko Denshi Co., Ltd., Minamiakita-gun, Akita 010-01 (JP)
(74) Representative: Prüfer, Lutz H., Dipl.-Phys.
(86) International application number: PCT/JP1997/003067
(87) International publication number: WO 1998/010439

(56) References cited:
- EP-A- 0 764 954
- EP-A- 0 785 557
- JP-A- 4 328 805
- JP-A- 4 343 207
- JP-A- 5 145 271
- JP-A- 6 204 021
- PATENT ABSTRACTS OF JAPAN vol. 017, no. 528 (E-1437), 22 September 1993 (1993-09-22) & JP 05 145271 A (BANDO CHEM IND LTD), 11 June 1993 (1993-06-11)
- KWON H J ET AL: "THE MICROWAVE ABSORBING AND RESONANCE PHENOMENA OF Y-TYPE HEXAGONALFERRITE MICROWAVE ABSORBERS" JOURNAL OF APPLIED PHYSICS,US,AMERICAN INSTITUTE OF PHYSICS. NEW YORK, vol. 75, no. 10, PART 02A, 15 May 1994 (1994-05-15), pages 6109-6111, XP000457046 ISSN: 0021-8979
- SMIT J. & WIJN H. P. J.: "Ferrites", 1959, N. V. PHILIPS' GLOEILAMPENFABRIEKEN, EINDHOVEN

## Description

### Technical Field

The present invention relates to a composite magnetic body in which soft magnetic powder is kneaded with and dispersed into an organic binding agent and, more specifically, to a composite magnetic body excellent in complex permeability property effective for suppressing electromagnetic interferences which is a problem in a high frequency electronic circuit/device, a method of producing the same and an electromagnetic interference suppressing body constituted of that composite magnetic body.

Particularly, the present invention relates to a composite magnetic body which is excellent in flexibility, stickable to, for example, an FPC (Flexible Printed Circuit), an FFC (Flexible Flat Cable) or a casing of an electronic equipment and further excellent in fire resistance, a method of producing the same and an electromagnetic interference suppressing body constituted of that composite magnetic body.

### Background Art

As digital electronic equipments which have been rapidly spread in recent years, there are logic circuits, logic elements and the like, such as a random access memory (RAM), a read-only memory (ROM), a microprocessor (MPU), a central processing unit (CPU), an image processor arithmetic and logic unit (IPALU), or the like. The logic circuit or the logic element is constituted of an LSI or IC composed of a large number of semiconductor devices being active elements, and mounted on a printed circuit board. In the logic circuit or the logic element, the speed-up of the operation speed and the speed-up of the signal processing speed have been achieved. Since a signal changing at high speed in such a logic circuit or the like goes with abrupt changes in voltage and current, an active element generates inductive noise and thus is a cause of high frequency noise generation. The high frequency noise causes interactions cooperatively with crosstalk noise or noise due to impedance mismatch. Further, the high frequency noise relies much on the inductive noise caused by the active element. Due to the inductive noise, high frequency magnetic fields are induced at the same surface as an element mounting surface of the circuit board and an opposite surface thereof.

Further, the reduction in weight, thickness and size of the electronic equipments and the electronic devices has been rapidly advanced. Following this, the mounting density of the electronic components onto the printed circuit board has also been rapidly enhanced. Due to the foregoing induced high frequency magnetic fields, since the crammingly mounted electronic components, the printed wiring of the signal lines and the like or the inter-module wiring extremely approaches mutually and further since the speed-up of the signal processing speed is achieved as described above, not only the inter-line coupling due to the electromagnetic coupling is increased in the circuit board, but also the interference or the like due to the radiant noise is generated.

Further, when the radiant noise generates, it is possible that the radiant noise is radiated to the exterior via external connecting terminals to adversely affect other equipments. The malfunction of the electronic equipment and the adverse influence to other equipments due to the electromagnetic waves as described above are generally called electromagnetic interferences.

Conventionally, against such a radiated electromagnetic interference, a countermeasure has been generally taken, for example, to connect a filter to a circuit which produces the inductive noise in the electronic equipment, to dispose a circuit in question (circuit producing the inductive noise) at a distance from a circuit which is subjected to an influence, to carry out shielding or to carry out grounding.

For efficiently dealing with the foregoing electromagnetic interference in the printed circuit board or the like on which electronic components including active elements are mounted in high density, the conventional countermeasure (noise suppressing method) has drawbacks that expert knowledge and experience for the noise countermeasure are required and that it takes time for the countermeasure.

Particularly, the foregoing filter mounting has drawbacks that a filter to be used is expensive, that there often exists the limitation to the mounting space for a filter, that a mounting operation of a filter goes with difficulties, and that, since a filter or the like is used, the number of required processes for assembling an electronic device is increased to cause an increase in cost.

Conventionally, the method of suppressing the mutual interferences due to electromagnetic induction between signal lines generated between electronic components in the same circuit and due to undesired electromagnetic waves is not sufficient.

Further, for achieving the reduction in size and weight of the electronic device, the method of disposing the circuit in question at a distance is inconvenient and requires elimination of the filter and the mounting space thereof.

In the general printed circuit board used in the electronic device, since the electromagnetic coupling between signal lines such as electromagnetic induction generated in the board is relatively small at low frequencies, it raises no problem. On the other hand, as the operation frequency increases, the electromagnetic coupling between the signal lines are strengthened so that the foregoing problems are raised.

Further, in the foregoing shielding, since conductor shielding is an electromagnetic interference countermeasure utilizing the reflection of electromagnetic waves induced by impedance mismatch with the space, even if a shield effect is achieved, the electromagnetic coupling due to the reflection from an undesired radiation source is promoted. As a result, not a few cases have occurred where the secondary electromagnetic interference is induced.

As a secondary electromagnetic interference countermeasure, suppression of undesired radiation utilizing a magnetic loss of a magnetic body is effective. Specifically, by disposing a magnetic body having a large magnetic loss between the foregoing shield body and the undesired radiation source, the undesired radiation can be suppressed. Since a thickness d of the magnetic body is in inverse proportion to µ" at a frequency band satisfying a relationship of µ''>µ', a magnetic body with a large imaginary part permeability µ" is required for obtaining a thin electromagnetic interference suppressing body satisfying the foregoing demand for the reduction in size and weight of the electronic equipment, that is, a composite body composed of a shield body and a magnetic body. Further, since components of the foregoing undesired radiation are often spread over a wide frequency range, it is sometimes difficult to specify those frequency components that relate to the electromagnetic interference. Accordingly, it is desired that the foregoing electromagnetic interference suppressing body can also deal with the undesired radiation over wider frequencies.

The Patent Abstract of Japan, Vol. 017, No. 528 & JP 05145271 A discloses a cylindrical apparatus for shielding electromagnetic wave comprising a layer made of a composite material which contains a ferrite and, as a fire-resistant organic binding agent, chlorinated polyethylene. The ferrite is based on Mn-Zn and contains MnO (30-70 wt.-%), ZnO (10-40 wt.-%) and Fe₂O₃ (10-60 wt.-%).

An object of the present invention is to provide a composite magnetic body used in an electromagnetic interference suppressing body which is effective for electromagnetic interference suppression inside a high frequency electronic device, particularly, a mobile communication device, and a method of producing the same.

In particular, the present invention is to provide a composite magnetic body excellent in flexibility and fire resistance, and a method of producing the same.

Another object of the present invention is to provide an electromagnetic interference suppressing body constituted of the foregoing composite magnetic body.

In particular, the present invention is to provide an electromagnetic interference suppressing body which is excellent in flexibility, stickable to, for example, an FPC, an FFC or a curved surface of a casing of an electronic equipment and further excellent in fire resistance.

### Disclosure of the Invention

According to the present invention, there is provided a composite magnetic sheet body according to claim 1 and an electromagnetic interference suppressing body according to claim 3. The present invention further provides a method of producing a composite magnetic sheet body according to claim 5.

Preferred embodiments are set forth in the sub-claims to claims 1, 3 and 5, respectively.

### Best Mode for Carrying Out the Invention

For obtaining a composite magnetic body which provides an anisotropic magnetic field (Hk) of a necessary strength corresponding to a desired magnetic loss characteristic, soft magnetic powder may be used which has one or more of a shape magnetic anisotropy, a crystal magnetic anisotropy, an induced magnetic anisotropy and an anisotropy due to a magnetic elastic effect (magneto-striction). Specifically, in the present invention, for achieving a plurality of magnetic resonances of mutually different frequencies and corresponding magnetic losses in a frequency band extended, a plurality of magnetic powders having anisotropic magnetic fields (Hk) of mutually different strengths may be mixed with each other.

As means other than the foregoing for achieving a plurality of magnetic resonances, it is possible to positively utilize properties peculiar to powder and a powder composite body, or a milling/spreading process of the powder, which will be described hereinbelow.

Specifically, firstly, there is a method of utilizing differentiation of powder characteristics obtained by processing a material of a single kind under a specific condition. Secondly, there is a method in which milling media used in the milling/spreading process of powder is soft magnetic media, such as steel balls, so as to positively utilize a so-called contamination phenomenon where soft magnetic abrasion powder is entrained due to abrasion of the media. Further, thirdly, there is a method of utilizing a difference in existence manner of single kind powders in a composite body. For example, anisotropic magnetic fields are dispersed due to a difference in magnetic interaction and orientation behavior between particle groups. One particle group exists in the same matrix as primary particles. In another particle group, particles are agglomerated with wetting therein being insufficient and therefore are extremely close to each other or in contact with each other.

Further, if the shape of a sample is a thin film or a sheet, an effective anisotropic magnetic field becomes an algebraic sum with a demagnetizing field due to the sample shape, so that an orientation control of material magnetic powder can also be positively used.

As a means for obtaining a plurality of anisotropic magnetic fields to be used in the present invention, any of these methods may be used. It is important to provide a plurality of anisotropic magnetic fields so as to achieve a desired magnetic loss band. In particular, among them, with respect to an anisotropic magnetic field which provides a magnetic resonance appearing at the lowest frequency side, it is necessary to set it to a value which provides a magnetic resonance at a frequency region lower than the lower limit of a desired electromagnetic interference suppressing frequency band, considering that dispersion of an imaginary part permeability (magnetic loss) occurs following reduction of a real part permeability.

As soft magnetic powder which can be used in the present invention, a metal soft magnetic material, such as an Fe-Al-Si alloy (Sendust), an Fe-Ni alloy (Permalloy), an amorphous alloy or the like having a large high frequency permeability, which has been powdered by milling and drawing-tearing processes, atomizing granulation or the like, can be typically cited. For ensuring non-conductivity of a composite magnetic body, being a necessary element of the present invention, even in a high-filling state of the soft magnetic powder, it is preferable that at least the surfaces thereof are oxidized so that the individual particles are electrically isolated.

Further, as the soft magnetic powder of the present invention, powder of an oxide soft magnetic body, such as spinel ferrite or planar ferrite, can be used. It can also be used as being mixed with the foregoing metal soft magnetic powder.

On the other hand, as an organic binding agent to be used as a secondary material of the present invention, chlorinated polyethylene is used for obtaining an effect the present invention aims at, that is, for obtaining excellent flexibility and fire resistance.

There is no particular limitation to means for obtaining a composite magnetic body by kneading and dispersing the foregoing constituent elements of the present invention. A preferable method may be selected based on a property of a binding agent to be used and facilitation of a process.

The composite magnetic body or the electromagnetic interference suppressing body of the present invention has a plurality of anisotropic magnetic fields (Hk) of mutually different strengths so that a plurality of magnetic resonances appear at mutually different frequency regions. Thus, imaginary part permeabilities µ" appearing at mutually different frequency regions following the plurality of magnetic resonances are superimposed so that a wideband µ" dispersion characteristic can be achieved. The imaginary part permeability µ" is a magnetic loss term necessary for absorbing electromagnetic waves so that if values of µ" are large and extend over a wide band, an excellent electromagnetic interference suppressing effect appears.

Further, since the soft magnetic powder used in the present invention is oxidized at least on the surfaces thereof, the individual particles exist as being electrically isolated even at the high filling rate of the powder. Accordingly, not only deterioration of a frequency characteristic due to an eddy current loss as observed in a conductive bulk body is small, but also the reflection of electromagnetic waves on the surfaces due to impedance mismatch with the space becomes reluctant to occur, so that an excellent electromagnetic interference suppressing effect can be achieved at a high frequency region.

Hereinbelow, an example of a composite magnetic body by the present invention will be shown.

### Example

First, as shown in Table 1 below, 80 weight parts of soft magnetic powder (Fe-Al-Si alloy, mean particle diameter: 35 µm, aspect ratio: not less than 5) and 0.8 weight parts of a titanate coupling agent are agitated by a mixer so that the soft magnetic powder is subjected to the coupling in advance. Then, as shown in Table 1, 80 weight parts of the soft magnetic powder subjected to the coupling and 20 weight parts of an organic agent (chlorinated polyethylene) are kneaded by a kneader to obtain a composite magnetic body.

Then, the obtained composite magnetic body is passed through between rolls arranged in parallel to be rolled and thus formed into a sheet. Through this, an electromagnetic interference suppressing body having excellent flexibility and fire resistance can be obtained.

**Table 1**

| | |
|---|---|
| Soft magnetic powder | 80 weight parts |
| Fe-Al-Si alloy | |
| Mean particle diameter: 35 µm | |
| Aspect ratio: >5 | |
| Titanate coupling agent | 0.2 weight parts |
| Organic binding agent | 20 weight parts |
| (chlorinated polyethylene) | |

### Industrial Applicability

As described above, the composite magnetic body of the present invention or the electromagnetic interference suppressing body using it has a plurality of anisotropic magnetic fields (Hk) of mutually different strengths so that a plurality of magnetic resonances appear at mutually different frequency regions. Thus, a wideband µ" dispersion characteristic can be achieved. The imaginary part permeability µ" is a magnetic loss term necessary for absorbing electromagnetic waves so that if values of µ" are large and extend over a wide band, an excellent electromagnetic interference suppressing effect appears. That is, there can be provided a thin electromagnetic interference suppressing body which is effective for suppressing electromagnetic wave interferences inside a high frequency electronic equipment including a mobile communication equipment.

Further, the composite magnetic body of the present invention uses chlorinated polyethylene as an organic binding agent so as to have excellent flexibility and fire resistance. Thus, the electromagnetic interference suppressing body of the present invention is stickable to, for example, an FPC or FFC and even to a casing, having a complicate shape, of an electronic equipment, and further can respond to a strict requirement for fire resistance,

## Claims

1. A composite magnetic sheet body of an electrically nonconductive magnetic material substantially composed of soft magnetic powder and, as an organic binding agent, chlorinated polyethylene, **characterized in that** said composite magnetic body has a plurality of magnetic resonances, said plurality of magnetic resonances appear at mutually different frequency regions, respectively, corresponding to the anisotropic magnetic fields of the mutually different strengths, and the lowest one among said plurality of magnetic resonances exists in a frequency region lower than a lower limit of an electromagnetic interference suppressing frequency band generated by said composite magnetic layer,
wherein said soft magnetic powder is a mixed body of soft magnetic powder of at least two kinds having magnetic anisotropies of different stengths.

2. A composite magnetic sheet body as recited in claim 1, **characterized in that** said plurality of magnetic resonances appearing at the mutually different frequency regions are induced by a plurality of anisotropic magnetic fields (Hk) having mutually different strengths.

3. An electromagnetic interference suppressing body substantially made of a composite magnetic sheet body as defined in claim 1.

4. An electromagnetic interference suppressing body as recited in claim 3, **characterized in that** said soft magnetic powder is provided with oxide layers on surfaces thereof.

5. A method of producing a composite magnetic sheet body **characterized by** mixing soft magnetic powder of at least two kinds having magnetic anisotropies of mutually different strengths and chlorinated polyethylene used as an organic binding agent, and subjecting them to shaping so as to obtain the composite magnetic sheet body being electrically nonconductive and having at least two magnetic resonances induced by anisotropic magnetic fields (Hk) of mutually different strengths.

6. A method of producing a composite magnetic sheet body as recited in claim 5, **characterized in that** said soft magnetic powder has oxide layers on surfaces thereof.

7. A method of producing a composite magnetic sheet body as recited in claim 5, **characterized in that** said soft magnetic powder is surface oxidized by an oxygen containing mixed gas in a stage prior to mixing with said organic binding agent or during mixing, using a gas phase acid removing method or a liquid phase acid removing.method.

## Patentansprüche

1. Magnetischer Komposit-Lagenkörper eines elektrisch nicht leitenden magnetischen Materials, welches sich im wesentlichen zusammensetzt aus weichmagnetischem Pulver und, als einem organischen Bindemittel, chloriertem Polyethylen, **dadurch gekennzeichnet, daß** der magnetische Kompositkörper eine Vielzahl magnetischer Resonanzen aufweist, wobei die Vielzahl magnetischer Resonanzen jeweils bei sich voneinander unterscheidenden Frequenzbereichen in Erscheinung treten, entsprechend den anisotropen Magnetfeldern der voneinander verschiedenen Stärken, und wobei die Niedrigste unter der besagten Vielzahl der magnetischen Resonanzen in einem Frequenzbereich vorkommt, der niedriger ist als die untere Grenze eines Frequenzbands der Unterdrückung elektromagnetischer Interferenz, das durch die magnetische Kompositschicht erzeugt wird, wobei das weichmagnetische Pulver ein Mischkörper von weichmagnetischem Pulver von mindestens zwei Arten ist, die magnetische Anisotropien unterschiedlicher Stärken aufweisen.

2. Magnetischer Komposit-Lagenkörper wie im Anspruch 1 angegeben, **dadurch gekennzeichnet, daß** die Vielzahl magnetischer Resonanzen, die in den voneinander verschiedenen Frequenzbereichen in Erscheinung treten, durch eine Vielzahl anisotroper Magnetfelder (Hk) mit voneinander verschiedenen Stärken induziert werden.

3. Körper zur Unterdrückung elektromagnetischer Interferenz, der im wesentlichen aus einem magnetischen Komposit-Lagenkörper wie in Anspruch 1 definiert gefertigt ist.

4. Körper zur Unterdrückung elektromagnetischer Interferenz wie in Anspruch 3 angegeben, **dadurch gekennzeichnet, daß** das weichmagnetische Pulver mit Oxidschichten auf Oberflächen davon versehen ist.

5. Verfahren zur Herstellung eines magnetischen Komposit-Lagenkörpers, **gekennzeichnet durch** das Vermischen eines weichmagnetischen Pulvers von mindestens zwei Arten, die magnetische Anisotropien von voneinander verschiedenen Stärken aufweisen, und als einem organischen Bindemittel verwendetem chloriertem Polyethylen, und dessen Unterziehen einer Formgebung, um einen magnetischen Komposit-Lagenkörper zu erhalten, der elektrisch nicht leitend ist und mindestens zwei magnetische Resonanzen aufweist, die **durch** anisotrope Magnetfelder (Hk) von voneinander verschiedenen Stärken induziert sind.

6. Verfahren zur Herstellung eines magnetischen Komposit-Lagenkörpers wie im Anspruch 5 angegeben, **dadurch gekennzeichnet, daß** das weichmagnetische Pulver Oxidschichten auf Oberflächen davon aufweist.

7. Verfahren zur Herstellung eines magnetischen Komposit-Lagenkörpers wie im Anspruch 5 angegeben, **dadurch gekennzeichnet, daß** das weichmagnetische Pulver oberflächenoxidiert wird durch ein Sauerstoff-enthaltendes Mischgas in einer Stufe vor dem Vermischen des organischen Bindemittels oder während des Mischens, unter Verwendung einer Gasphasen-Säureentfernungsmethode oder einer Flüssigphasen-Säureentfernungsmethode.

## Revendications

1. Corps de feuille magnétique composite en matériau magnétique électriquement non-conducteur composé essentiellement d'une poudre magnétique douce et, comme agent liant organique, de polyéthylène chloré,
**caractérisé en ce que**
le corps magnétique composite présente une pluralité de résonances magnétiques, cette pluralité de résonances magnétiques apparaissant dans des zones de fréquences mutuellement différentes correspondant respectivement à des champs magnétiques anisotropes de forces mutuellement différentes, et la plus basse de cette pluralité de résonances magnétiques se trouvant dans une zone de fréquences inférieure à la limite inférieure d'une bande de fréquences de suppression d'interférences électromagnétiques générées par la couche magnétique composite, la poudre magnétique douce étant un corps mélangé de poudre magnétique douce d'au moins deux types ayant des anisotropies magnétiques de forces différentes.

2. Corps de feuille magnétique composite selon la revendication 1,
**caractérisé en ce que**
la pluralité de résonances magnétiques apparaissant dans les zones de fréquences mutuellement différentes sont induites par une pluralité de champs magnétiques anisotropes (Hk) ayant des forces mutuellement différentes.

3. Corps de suppression d'interférences électromagnétiques constitué essentiellement d'un corps de feuille magnétique composite tel que défini dans la revendication 1.

4. Corps de suppression d'interférences électromagnétiques selon la revendication 3,
**caractérisé en ce que**
la poudre magnétique douce est munie de couches d'oxyde sur ses surfaces.

5. Procédé de fabrication d'un corps de feuille magnétique composite,
**caractérisé en ce que**
il consiste à :
- mélanger une poudre magnétique douce d'au moins deux types ayant des anisotropes magnétiques de forces mutuellement différentes, avec du polyéthylène chloré utilisé comme agent liant organique, et
- les soumettre à une mise en forme pour obtenir le corps de feuille magnétique composite qui est électriquement non conducteur et présente au moins deux résonances magnétiques induites par des champs magnétiques anisotropes (Hk) de forces mutuellement différentes.

6. Procédé de fabrication d'un corps de feuille magnétique composite selon la revendication 5,
**caractérisé en ce que**
la poudre magnétique douce comporte des couches d'oxyde sur ses surfaces.

7. Procédé de fabrication d'un corps de feuille magnétique composite selon la revendication 5,
**caractérisé en ce que**
la poudre magnétique douce est oxydée en surface par un mélange de gaz contenant de l'oxygène, dans une étape précédant le mélange avec l'agent liant organique ou pendant ce mélange, en utilisant un procédé d'extraction d'acide en phase gazeuse ou un procédé d'extraction d'acide en phase liquide.
